# EUROPEAN PATENT APPLICATION

(11) **EP 0 945 880 A2**
(43) Date of publication of application: **29.09.1999**
(21) Application number: 99106318.1
(22) Date of filing: 26.03.1999
(51) Int. Cl.: H01F 27/29, H01F 17/04

(54) **Surface-mount coil**

(30) Priority: 27.03.1998 JP 8107998
(71) Applicant: TAIYO YUDEN Co., Ltd., Taito-ku Tokyo (JP)
(72) Inventor: Kuroiwa, Katsutoshi, Tokyo (JP); Tajima, Takashi, Tokyo (JP)
(74) Representative: TER MEER STEINMEISTER & PARTNER GbR

(57) **Abstract**

A surface-mount coil comprising a coil body including a core (5) with a wind frame portion (3) ofwhich winding is applied. The core (5) comprising the wind frame portion (3) and upper and lower flange portions (1, 2) formed to extend at opposite ends of the wind frame portion (3), and lead frames (10', 11') including external connection terminals (6, 7) to surfaces of which solderable layers (31) are bonded and core placing portions (8, 9) extending from the external connection terminals (6, 7) and having widths larger than widths of the external connection terminals (6, 7). The coil body being fixed by bonding to upper faces (8a, 9a) of the core placing portions (8, 9) of the lead frames (10', 11'), and end portions of the winding being conductively connected to the lead frames (10', 11'), The solder adhesion preventing layers (25) are formed at lower faces (8A, 9A) of the core placing portions (8, 9) of the lead frames (10', 11'), or at boundary portions (33) between the external connection terminals (6, 7) and the core placing portions (8, 9) at lower faces of the lead frames (10', 11').

## Description

The present invention relates to a surface-mount coil such as a choke coil, and particularly to a structure of lead frames of a surface-mount coil in which a plurality of external connection terminals are directly disposed on a bottom face side of a lower flange portion of a drum-shaped core body.

Conventionally, a structure in which a core comprising a wind frame portion provided with a winding, and upper and lower flange portions formed to extend at opposite ends of the wind frame portion is fixed by bonding to a pedestal made of synthetic resin mounted with external connection terminals, and end portions of the winding are tied to and soldered to roots of the external connection terminals was a main stream ofthe surface-mount coil such as the choke coil. Recently, however, a structure wherein lead frames having external connection terminals are directly fixed through an adhesive or the like to the bottom face of the lower flange portion of the core made of ferrite, ceramic, or the like, for example, has been frequently employed at the request of decreasing a height.

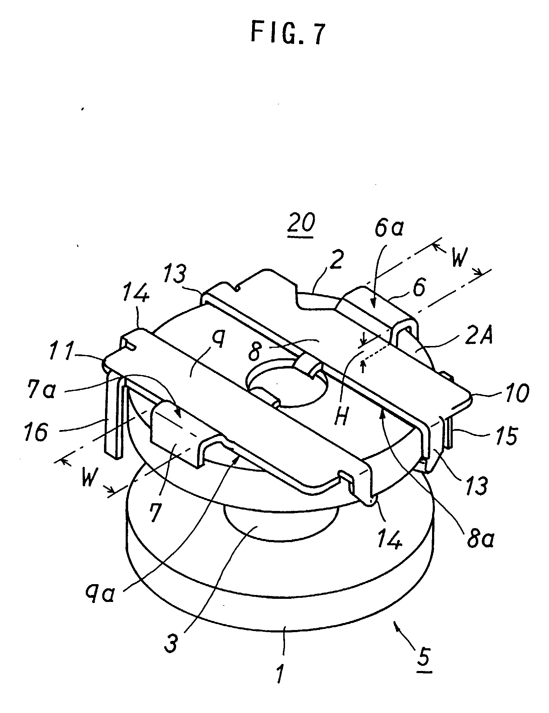

Figure 7 is a perspective view of a conventional surface-mount coil seen from a bottom face side (mount board side) and which is of a type as disclosed in Japanese Patent Application Laid-open No. 9-213539, wherein an electrode is directly fixed by bonding to the lower flange portion of the drum-shaped core.

In Figure 7, a surface-mount coil 20 comprises a coil body including a core 5 with a wind frame portion 3 of which a winding (not shown) is applied. The core 5 consists of the wind frame portion 3 and upper and lower flange portions 1 and 2 formed to extend at opposite ends of the wind frame portion 3, lead frames 10 and 11 including external connection terminals 6 and 7 to surfaces of which solderable layers (such as tinning layers, copper plating layers, gold plating layers, solder plating layers, and the like which have a solder wetting property equal to or better than that of lead frame material are bonded, and core placing portions 8 and 9 extending from the external connection terminals and having widths larger than widths W of the external connection terminals. A bottom face of the lower flange portion 2 of the coil body is fixed by bonding through an adhesive or the like to upper faces 8a and 9a (lower invisible faces in Figure 7) of the core placing portions 8 and 9 of the lead frames, and end portions of the winding are conductively connected by soldering to packing terminals 15 and 16 of the lead frames 10 and 11.

Height differences H are formed at boundary portions between the external connection terminals 6 and 7 and the core placing portions 8 and 9. Reference numerals 13 and 14 designate engaging projections formed on the lead frames 10 and 11 for positioning of the lead frames 10 and 11 to the coil body.

In the above conventional surface-mount coil 20, by disposing the wide core placing portions 8 and 9 at higher positions by height differences H than the external connection terminals 6 and 7 in the lead frames 10 and 11 (by a bending processing), insulation between a wiring pattern in the mount board face right under the lead frames and the lead frames is maintained.

However, as a size and a height of the above surface-mount coil 20 are further decreased thereby decreasing the height differences H, when the surface-mount coil 20 is mounted on electrode lands of a circuit board coated with solder paste and the solder paste is melted and hardened through a reflow soldering furnace to solder the electrode lands to the external connection terminals 6 and 7 of the surface-mount coil, because molten solder moves and diffuses from surfaces of the external connection terminals 6 and 7 of the lead frames 10 and 11 toward lower faces of the core placing portions 8 and 9 with large widths, an amount of solder detained in vicinity of the external connection terminals 6 and 7 decreases. As a result, fillet is not sufficiently formed, and there is a strong possibility that a product is judged defective in soldering in visual inspection of soldering.

In a surface-mount coil without height differences H, if the surface-mount coil is mounted not horizontally but slightly slantwise on the electrodes of the circuit board relative to a board surface, gaps are generated between the electrode lands of the circuit board and the lower faces of the core placing portions of the lead frames, and the molten solder enters and adheres to the gaps, thereby easily generating a defect in soldering similarly to the above technique.

On the other hand, in response to recent rising tide of environmental protection, a movement for removing lead included in conventional solder has been promoted. Use of lead-free solder (including approximately 96 wt% of tin, and 4 wt% of silver, bismuth, copper, or a mixture ofthem as the remainder) is considered to increase in the future.

However, because a melting point of the lead-free solder is higher than that of low-temperature solder (tin-lead eutectic solder including about 10% of lead and having a melting point of about 220 °C) which is used conventionally, wetting cannot be obtained unless a temperature of the external connection terminals 6 and 7 of the lead frames 10 and 11 is sufficiently increased in soldering. On the other hand, because the lead frames 10 and 11 are inevitably exposed to the high temperature for a long time in this case, the molten solder can easily enter to reach the core placing portions 8 and 9 with high temperatures. As a result, the above problem of the defect in soldering is further highlighted.

The present invention has been accomplished with the above circumstances in view, and provides a surface-mount coil with a structure for decreasing a defect in soldering of external connection terminals of lead frames to a circuit board.

To achieve the above object, according to the present invention, there is provided (1) a surface-mount coil comprising a coil body including a core with a wind frame portion of which winding is applied, the core having the wind frame portion and upper and lower flange portions formed to extend at opposite ends of the wind frame portion, and lead frames including external connection terminals to surfaces of which solderable layers are bonded and core placing portions extending from the external connection terminals and having widths larger than widths of the external connection terminals, the coil body being fixed by bonding to upper faces of the core placing portions of the lead frames, and end portions of the winding being conductively connected to the lead frames, wherein solder adhesion preventing layers are formed at lower faces of the core placing portions of the lead frames.

To achieve the above object, according to the present invention, there is provided (2) a surface-mount coil comprising a coil body including a core with a wind frame portion of which winding is applied, the core having the wind frame portion and upper and lower flange portions formed to extend at opposite ends of the wind frame portion, and lead frames including external connection terminals to surfaces of which solderable layers are bonded and core placing portions extending from the external connection terminals and having widths larger than widths of the external connection terminals, the coil body being fixed by bonding to upper faces of the core placing portions of the lead frames, and end portions of the winding being conductively connected to the lead frames, wherein solder adhesion preventing layers are formed at boundary portions between the external connection terminals and the core placing portions at lower faces of the lead frames.

To achieve the above object, according to the present invention, there is provided (3) a surface-mount coil according to the above (1) or (2), wherein the solder adhesion preventing layers are formed before forming of the solderable layers.

Embodiments of the present invention will be specifically described based on the drawings. The same reference numerals and/or letters are used to refer to members similar to those of prior art.

Figure 1 is a perspective view of a surface-mount coil according to the present invention, and Figure 2 is a perspective view (winding is omitted) of the surface-mount coil according to a first embodiment and seen from a back face side. Figure 3 is a side view of the surface-mount coil mounted on a mount board face. Figure 4 is an enlarged view showing shapes of lead frames of the present invention. Figure 5(a) is an enlarged view showing a state of soldering of external connection terminals and core placing portions of the lead frames of the surface-mount coil according to the first embodiment, and Figure 5(b) is an enlarged view showing a state of soldering of external connection terminals and core placing portions of the lead frames of the surface -mount coil according to a second embodiment of the present invention. Figure 6 is an enlarged view showing shapes of the lead frames according to the second embodiment of the present invention before bending.

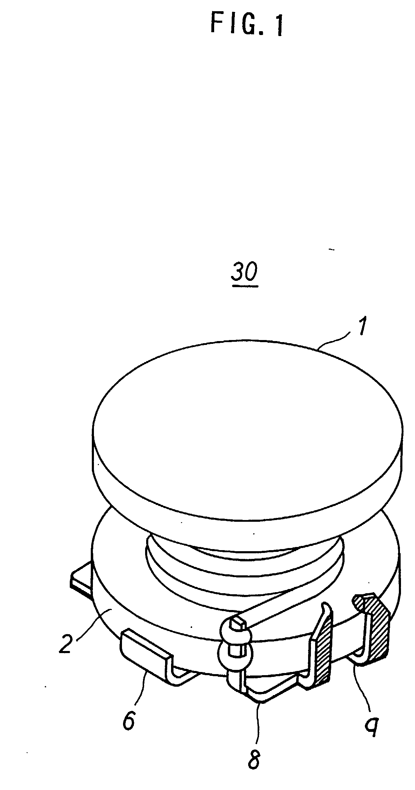

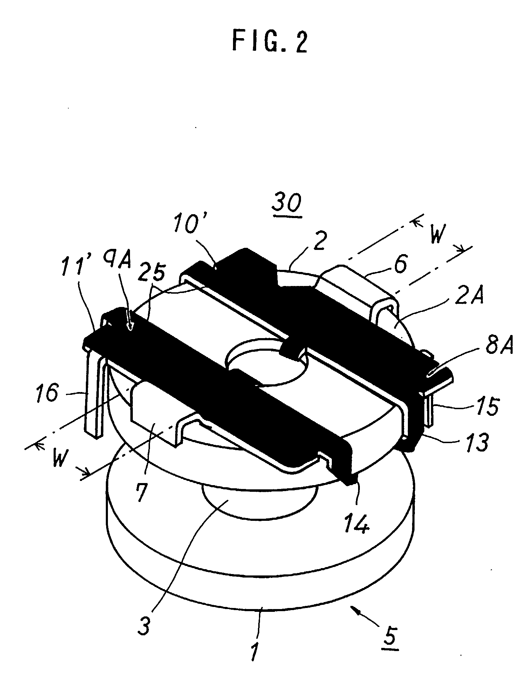

In Figures 1 to 4, a surface-mount coil 30 (e. g., choke coil) according to the present invention comprises a coil body including a core 5 with a wind frame portion 3 of which a winding is applied. The core 5 comprises the wind frame portion 3 and upper and lower flange portions 1 and 2 formed to extend at opposite ends of the wind frame portion 3, and lead frames 10' and 11' including external connection terminals 6 and 7 to surfaces of which solderable layers (such as tinning or solder plating with a thickness of 1 to 20 µm) are bonded and core placing portions 8 and 9 extending at positions higher than the external connection terminals 6, 7 by height differences H and having widths larger than widths W of the external connection terminals similarly to the above-described conventional surface-mount coil 20. A bottom face 2A of the lower flange portion 2 of the coil body is fixed by bonding through an adhesive or the like to upper faces 8a and 9a (lower invisible faces in Figure 2) of the core placing portions 8 and 9 of the lead frames 10', 11', and end portions of the winding are conductively connected by soldering to packing terminals 15 and 16 of the lead frames 10' and 11'.

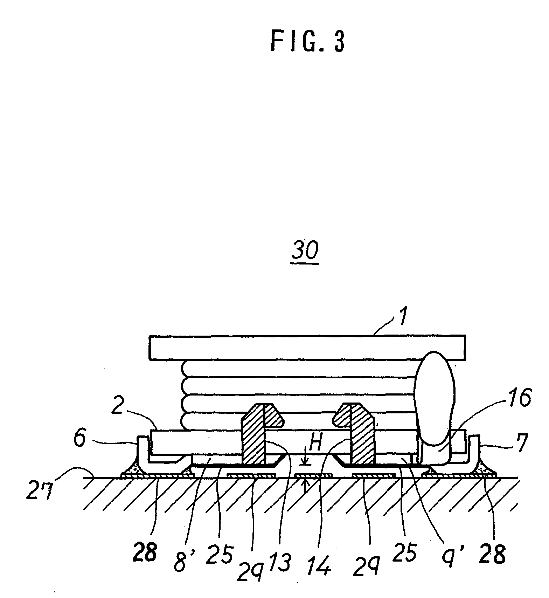

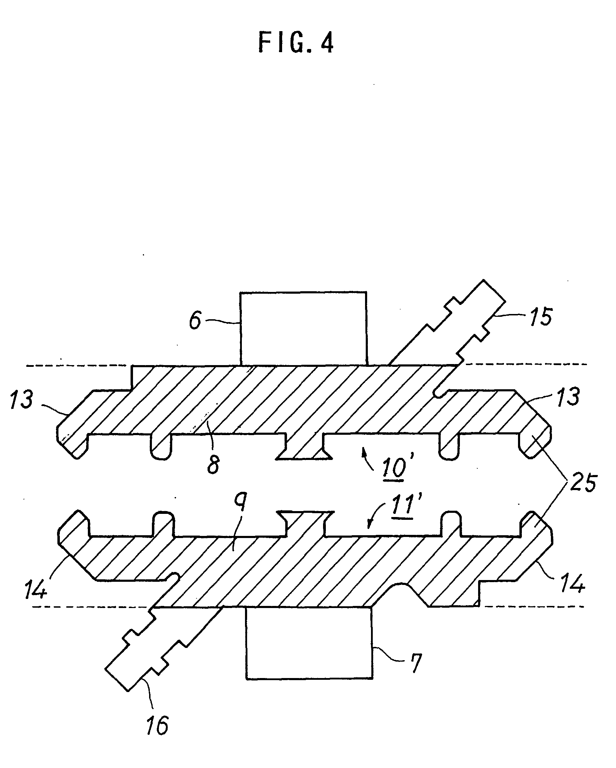

In addition to the above structure, the lead frames 10' and 11' are particularly characterized in that the lower faces 8A and 9A (on a mount board 27 side in Figure 3 and the upper visible faces in Figure 2) of the core placing portions 8 and 9 which are not in contact with the core 5 are provided with solder adhesion preventing layers 25 (black-colored portions in Figure 2 and diagonally shaded areas in Figure 4). The solder adhesion preventing layer 25 is a layer having such a property that solder adheres hard to the layer as compared with the lead frame material metal, and is a layer formed by hardening synthetic resin such as epoxy resin, fluoroplastics, or borosilicate glass paste and having a thickness of 10 to 200 µm preferably in terms of effects.

When electrode lands 28 of a mount board 27 and the external connection terminals 6 and 7 of the surface-mount coil 30 are soldered to each other, diffusion of molten solder to the lower faces of the core placing portions 8 and 9 is suppressed by the solder adhesion preventing layers 25 mounted to the lower faces of the core placing portions 8 and 9 of the lead frames 10' and 11'. As a result, the molten solder is detained on the electrode lands 28 to form a sufficient solder fillet on the external connection terminals 6 and 7, and thus, a defect in soldering is not easily generated, and a desirable appearance of soldering can be obtained.

Also, because the solder adhesion preventing layer 25 has an insulation property, by the structure in which the lower faces of the core placing portions 8 and 9 of the lead frames are covered with the solder adhesion preventing layers 25, other circuit wiring patterns 29 can be disposed right under the surface-mount coil 30 mounted on the mount board 27 while decreasing a height of the surface-mount coil 30 (i. e., maintaining the same differences H as those of prior art), thereby contributing increasing of density, as shown in Figure 3.

By the structures of the lead frames 10' and 11', a defect of soldering can be decreased, and insulation between the lead frames 10', 11' and the mount board can be ensured. Therefore, if a foreign matter which is a conductor exists in gaps between the core placing portions 8 and 9 and the circuit wiring patterns 29 of the mount board 27 having the height differences H therebetween, insulation property of the surface-mount coil 30 can be maintained. Also, the above height differences H can be set to be as small as possible, thereby decreasing the height of the coil (however, it is important to maintain at least minimal height differences H so as to ensure the contact between the external connection terminals 6 and 7 and the electrode lands 28 of the mount board 27).

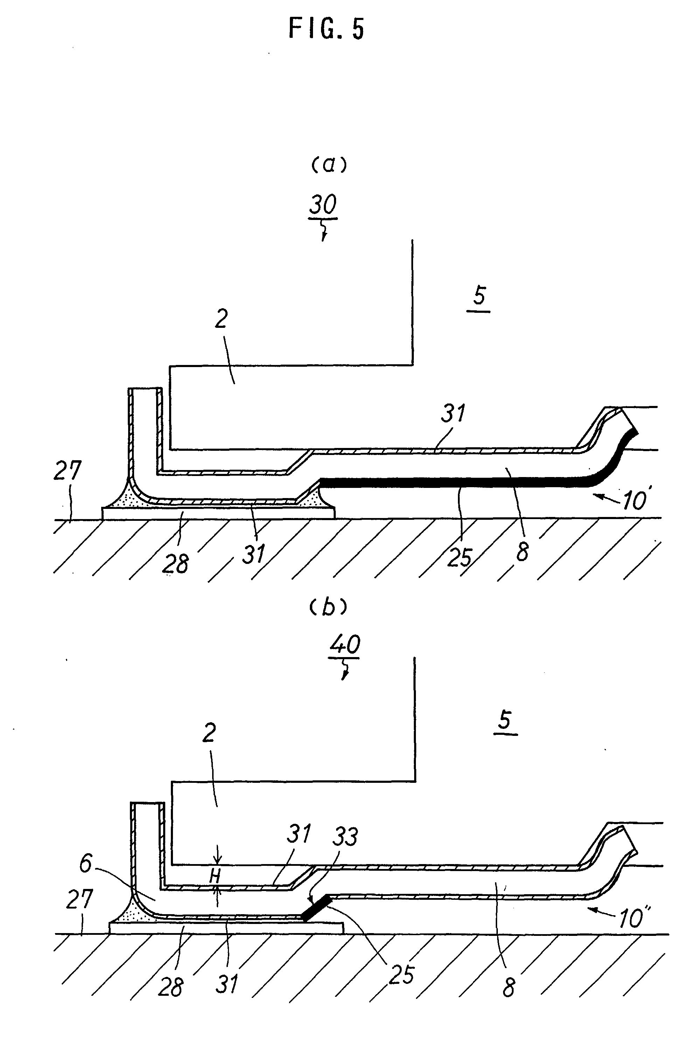

As shown in Figure 5(a), the surface-mount coil 30 is characterized in that the solder adhesion preventing layers 25 are formed before forming of the solderable layers 31 (by immersing an entire metal frame 40 in a plating bath, for example).

In other words, the solder adhesion preventing layers 25 are formed by printing, transcription, or the like on belt-shaped metal plates (material of which is phosphor bronze, bronze, copper, or the like). Then, bending of the external connection terminals 6 and 7 and the like and solder plating treatment of the external connection terminals 6 and 7 and the packing terminals 15 and 16 are carried out.

In this structure, because the solder adhesion preventing layers 25 are formed directly on lower faces of the core placing portions 8 and 9 of the lead frames 10' and 11', a securing strength of the solder adhesion preventing layers 25 is large. Therefore, when the surface-mount coil 30 is soldered to the mount board 27, the solder adhesion preventing layers 25 are not peeled off, even if the solderable layers 31 formed by tinning or solder plating are melted by a heat of soldering. If the solder adhesion preventing layers 25 are formed after forming of the solderable layers 31 on entire lead frames, the solder adhesion preventing layers 25 are peeled off as the solderable layers 31 are melted and softened due to a heat generated in soldering.

If the solder adhesion preventing layers 25 are formed only for an object of preventing the defect in soldering of the external connection terminals 6 and 7 to the mount board 27, the object can be achieved by a structure in which the solder adhesion preventing layer 25 is formed at a boundary portion 33 (which forms the height difference H) between the external connection terminal 6 and the core placing portion 8 at the lower face of the lead frame 10" as shown in Figure 5(b) which is an enlarged view showing a soldering state of the external connection terminal 6 and the core placing portion 8 of the lead frame 10" of the surface-mount coil 40, without forming the solder adhesion preventing layer 25 on an entire lower face of the core placing portion 8 of the lead frame 10".

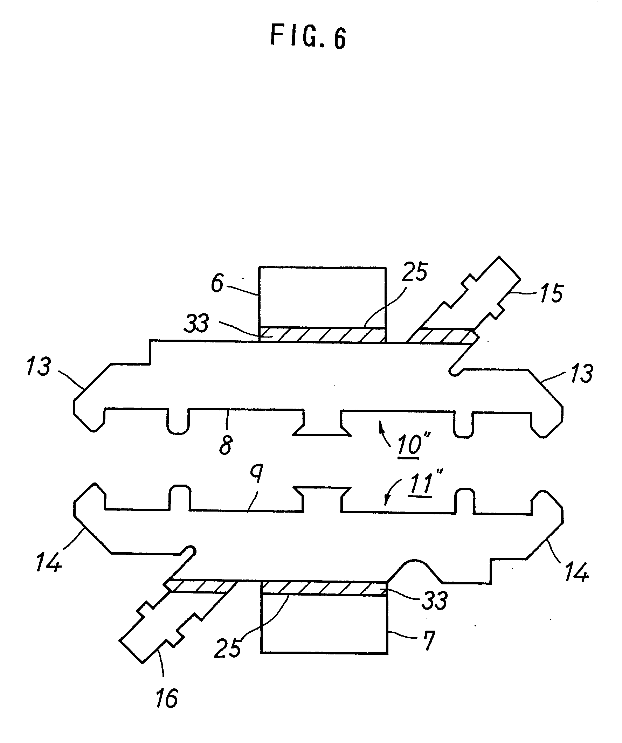

In other words, the solder adhesion preventing layer 25 at the boundary portion 33 functions as a breakwater for preventing diffusion of the molten solder of the core placing portion 8. In the lead frames 10" (and 11"), narrow belt-shaped solder adhesion preventing layers 25 are formed by printing on the boundary portions 33 of the respective lead frames 10" and 11", as shown in Figure 6. Of course, it is preferable that the solder adhesion preventing layers 25 are formed before forming of the solderable layers 31 in this case.

Because the surface-mount coil according to the present invention has a lead frame structure provided with the solder adhesion preventing layers as described above,
(1) the coil has an excellent effect of suppressing movement and diffusion of the molten solder in soldering (reflow soldering) of the external connection terminals 6, 7 to the electrode lands of the mount board by the solder adhesion preventing layers 25 and suppressing generation of defect in soldering.
(2) If the lower faces of the core placing portions of the lead frames are covered with the solder adhesion preventing layers 25, other circuit wiring patterns can be disposed right under the surface-mount coil mounted on the mount board to which the surface-mount coil is mounted while decreasing a height of the surface-mount coil, thereby contributing increasing of density.
(3) Because the solder adhesion preventing layers 25 are formed on the lead frame surfaces before forming of the solderable layers, the solderable layers do not exist in interfaces between the lead frame surfaces and the solder adhesion preventing layers even if a set temperature of the reflow solder is higher than that of the conventional tin-lead eutectic solder such as a lead-free solder. Therefore, even if the solderable layers are melted and softened in the heating treatment, the securing strength of the solder adhesion preventing layers is not easily decreased.

### Explanation of the reference numerals:

- 1: upper flange portion
- 2: lower flange portion
- 2A: bottom face of lower flange portion
- 3: wind frame portion
- 5: core
- 6, 7: external connection terminals
- 8, 9: core placing portions
- 8a, 9a: upper faces of core placing portions
- 8A, 9A: lower faces of core placing portions
- 10, 11, 10', 11', 10'', 11'': lead frames
- 13, 14: engaging projections
- 15, 16: packing terminals
- 20, 30, 40: surface-mount coil
- 25: solder adhesion preventing layer
- 27: mount board
- 28: electrode land
- 29: circuit wiring pattern
- 31: solderable layer
- H: height difference
- W: width of external connection terminal

## Claims

1. A surface-mount coil comprising a coil body including a core (5 ) with a wind frame portion (3) of which winding is applied, the core (5) comprising the wind frame portion (3) and upper and lower flange portions (1, 2) formed to extend at opposite ends of the wind frame portion (3), and lead frames (10', 11') including external connection terminals (6, 7) to surfaces of which solderable layers (31) are bonded and core placing portions (8, 9) extending from the external connection terminals (6, 7) and having widths larger than widths of the external connection terminals (6, 7), the coil body being fixed by bonding to upper faces (8a, 9a) of the core placing portions (8, 9) of the lead frames (10', 11'), and end portions of the winding being conductively connected to the lead frames (10', 11'), wherein solder adhesion preventing layers (25) are formed at lower faces (8A, 9A) of the core placing portions (8, 9) of the lead frames (10', 11').

2. A surface-mount coil comprising a coil body including a core (5) with a wind frame portion (3) of which winding is applied, the core (5) comprising the wind frame portion (3) and upper and lower flange portions (1, 2) formed to extend at opposite ends of the wind frame portion (3), and lead frames (10', 11') including external connection terminals (6, 7) to surfaces of which solderable layers (31) are bonded and core placing portions (8, 9) extending from the external connection terminals (6, 7) and having widths larger than widths of the external connection terminals (6, 7), the coil body being fixed by bonding to upper faces (8a, 9a) of the core placing portions (8, 9) of the lead frames (10', 11'), and end portions of the winding being conductively connected to the lead frames (10', 11'), wherein solder adhesion preventing layers (25) are formed at boundary portions (33) between the external connection terminals (6, 7) and the core placing portions (8, 9) at lower faces of the lead frames (10', 11').

3. The surface-mount coil according to claim 1 or 2, wherein the solder adhesion preventing layers (25) are formed before forming of the solderable layers (31).
